# EUROPEAN PATENT APPLICATION

(11) **EP 3 496 157 A1**
(43) Date of publication of application: **12.06.2019**
(21) Application number: 18197303.3
(22) Date of filing: 27.09.2018
(51) Int. Cl.: H01L 31/0224, H01L 31/0747

(54) **SOLAR CELL SHEET AND PREPARATION METHOD THEREOF, SOLAR CELL STRING AND PHOTOVOLTAIC MODULE**

(30) Priority: 05.12.2017 CN 201711268793; 05.12.2017 CN 201721672980 U
(71) Applicant: Beijing Juntai Innovation Technology Co., Ltd, 100176 Beijing (CN)
(72) Inventor: YU, Cao, BEIJING, 100176 (CN); YANG, Miao, BEIJING, 100176 (CN); XU, Xixiang, BEIJING, 100176 (CN)
(74) Representative: Cabinet Beau de Loménie

(57) **Abstract**

A solar cell sheet (100) includes: a conductive connection member (102); and a first electrode (10), a first transparent conductive layer (20), a first doped layer (30) of a first conductivity type, a first passivation layer (40), a monocrystalline silicon wafer (50), a second passivation layer (60), a second doped layer (70) of a second conductivity type, a second transparent conductive layer, and a second electrode (90) arranged in an order from top to bottom. One end of the conductive connection member (102) is electrically connected to the first electrode (10), and the other end of the conductive connection member (102) extends to a side of the second transparent conductive layer (80) adjacent to the second electrode (90), and the conductive connection member (102) is insulated from the second transparent conductive layer (80) and the second electrode (90).

## Description

### TECHNICAL FIELD

The present disclosure relates to the technical field of solar energy, and in particular, relates to a solar cell sheet and a preparation method thereof, a solar cell string and a photovoltaic module.

### BACKGROUND

With the development of solar cell technology, heterojunction solar cell has become one of the mainstream solar cells with its high efficiency and high stability. According to different installation methods and installation environments, the actual outdoor power generation of the heterojunction solar cells is 15%-30% higher than the actual outdoor power generation of conventional crystalline silicon cell. An important indicator for evaluating the performance of the heterojunction solar cells is the short-circuit current density Jsc. The larger the short-circuit current density Jsc is, the higher the efficiency of the heterojunction solar cell is.

### SUMMARY

The first aspect of the present disclosure provides a solar cell sheet, the solar cell sheet includes: a conductive connection member; and a first electrode, a first transparent conductive layer, a first doped layer of a first conductivity type, a first passivation layer, a monocrystalline silicon wafer, a second passivation layer, a second doped layer of a second conductivity type, a second transparent conductive layer, and a second electrode arranged in an order from top to bottom, one end of the conductive connection member is electrically connected to the first electrode, the other end of the conductive connection member extends to a side of the second transparent conductive layer adjacent to the second electrode, and the conductive connection member is insulated from the second transparent conductive layer and the second electrode.

The second aspect of the present disclosure further provides a method for preparing a solar cell sheet, and the method for preparing the solar cell sheet includes:
providing a first through hole in a monocrystalline silicon wafer, the monocrystalline silicon wafer comprising first and second surfaces which are opposite;
performing a texturing operation and a cleaning operation on both of the first and the second surfaces;
forming a first passivation layer and a first doped layer on the first surface sequentially, and forming a second passivation layer and a second doped layer on the second surface sequentially;
forming a first transparent conductive layer on a surface of the first doped layer away from the first passivation layer, and forming a second transparent layer on the surface of the second doped layer away from the second passivation layer; and
preparing a first electrode on a surface of the first transparent conductive layer away from the first doped layer, preparing a second electrode on a surface of the second transparent conductive layer away from the second doped layer, and preparing a conductive connection member located in the first through hole when preparing the first electrode or preparing the second electrode, such that one end of the conductive connection member is connected to the first electrode, and the other end of the conductive connection member extends to a side of the second transparent conductive layer adjacent to the second electrode.

A third aspect of the present disclosure further provides a solar cell string, including: a plurality of the solar cell sheets, the plurality of solar cell sheets are electrically connected together.

The fourth aspect of the present disclosure further provides a photovoltaic module, including a front plate, a first bonding layer, a solar cell string, a second bonding layer, and a backing plate in an order from top to bottom; wherein the solar cell string is the above solar cell string.

### BRIEF DESCRIPTION OF THE DRAWINGS

Fig. 1 is a structural schematic diagram of a solar cell sheet according to some embodiments of the present disclosure.
Fig. 2 is a schematic diagram of a cross section structure of a first solar cell sheet according to some embodiments of the present disclosure.
Fig. 3 is a schematic diagram of a cross section structure of a second solar cell sheet according to some embodiments of the present disclosure.
Fig. 4 is a schematic diagram of a cross section structure of a third solar cell sheet according to some embodiments of the present disclosure.
Fig. 5 is a structural schematic diagram of a through hole provided by a solar cell sheet according to some embodiments of the present disclosure.
Fig. 6 is a structural schematic diagram of a solar cell string according to some embodiments of the present disclosure.
Fig. 7 is a structural schematic diagram of a solar cell string according to some embodiments of the present disclosure.
Fig. 8 is a structural schematic diagram of a photovoltaic module according to some embodiments of the present disclosure.
Fig. 9 is a first flowchart of a method for preparing a solar cell sheet according to some embodiments of the present disclosure.
Fig. 10 is a second flowchart of a method for preparing a solar cell sheet according to some embodiments of the present disclosure.
Fig. 11 is a third flowchart of a method for preparing a solar cell sheet according to some embodiments of the present disclosure.
Fig. 12 is a flow chart showing the preparation method of the step 5 in Fig. 9 to Fig. 11.

### DETAILED DESCRIPTION

The embodiments of the present disclosure are described in detail below, and the examples of the embodiments are illustrated in the drawings, wherein the same or similar reference numerals are used to refer to the same or similar elements or elements having the same or similar functions. The embodiments described below with reference to the accompanying drawings are intended to be illustrative and explain the present disclosure only, and are not to be construed as limiting.

In the related art, the heterojunction solar cell has the characteristic of double-sided power generation. Therefore, both electrodes on two opposite surfaces of the heterojunction solar cell include a plurality of fine gate lines and a main gate line which are spaced apart. Since the main gate line blocks a part of a light receiving area of the heterojunction solar cell, the short-circuit current density of the heterojunction solar cell is reduced; accordingly, the photoelectric conversion efficiency of the heterojunction solar cell is reduced. The main gate line is made of silver material. Therefore, when the main gate line is made of a large amount of silver material, the cost of preparing the main gate line is very high.

In addition, the existing solar cell sheet cooperates with a special back plate integrated with positive and negative electrodes by a Metal Wrap Through (MWT) back contact technology to achieve an interconnection between two adjacent solar cells. However, since the special back plate integrated with the positive and negative electrodes is non-transparent, when the back plate of the solar cell is the special back plate integrated with positive and negative electrodes, the solar cell cannot realize the double-sided power generation function. Moreover, since the special back plate integrated with positive and negative electrodes is generally expensive, it is not conducive to the control of industrialization costs.

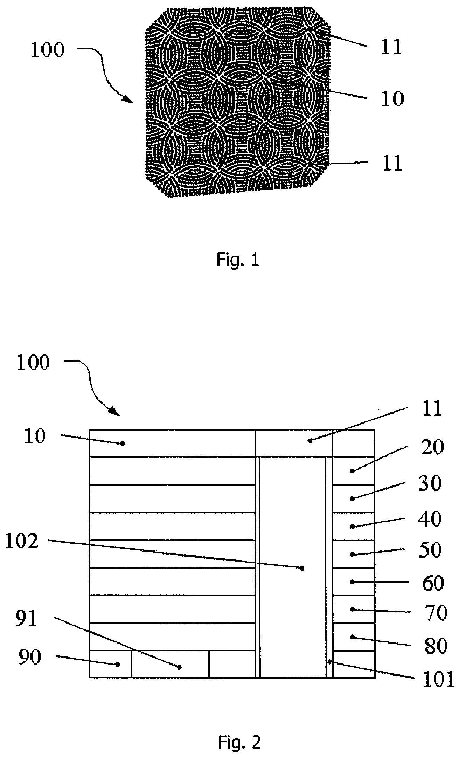

As shown in Fig. 1, in view of the above problems, some embodiments of the present disclosure provide a solar cell sheet. Compared with the heterojunction solar cell disclosed in the related art, the solar cell sheet has a relatively large light-receiving surface area, so that the short-circuit current density of the solar cell is higher than that of the heterojunction solar cell disclosed in the related art. Since the short-circuit current density of the solar cell sheet is higher than the short-circuit current density of the heterojunction solar cell disclosed in the related art, the photoelectric conversion efficiency of the solar cell sheet is high with respect to the photoelectric conversion efficiency of the heterojunction solar cell disclosed in the related art.

In conjunction with Fig. 1 to Fig. 4, a solar cell sheet 100 provided by some embodiments of the present disclosure includes: a conductive connection member 102; and a first electrode 10, a first transparent conductive layer 20, a first doped layer 30 of a first conductive type, a first passivation layer 40, a monocrystalline silicon wafer 50, a second passivation layer 60, a second doped layer 70 of a second conductive type, a second transparent conductive layer 80, and a second electrode 90 arranged from top to bottom for one time. One end of the conductive connection member 102 is electrically connected to the first electrode 10, and the other end of the conductive connection member 102 extends to a side of the second transparent conductive layer 80 adjacent to the second electrode 90.

It may be understood that, as shown in Fig. 1 to Fig. 4, when the other end of the conductive connection member 102 extends to a side of the second transparent conductive layer 80 adjacent to the second electrode 90, the conductive connection member 102 and the second transparent conductive layers 80 are insulated from each other, and the conductive connection member 102 and the second electrode 90 are insulated from each other. In some embodiments, when the other end of the conductive connection member 102 extends to a side of the second transparent conductive layer 80 adjacent to the second electrode 90, the other end of the conductive connection member 102 and the second electrode 90 are both located on the surface of the second transparent conductive layer 80 away from the second doped layer 70. From the perspective of electrical connection, since one end of the conductive connection member 102 is electrically connected to the first electrode 10, and the other end of the conductive connection member 102 extends to a side of the second transparent conductive layer 80 adjacent to the second electrode 90, a current extraction end of the first electrode 10 is located on a side of the second transparent conductive layer 80 adjacent to the second electrode 90. Since the current extraction end of the first electrode 10 is located on a side of the second transparent conductive layer 80 adjacent to the second electrode 90, the current extraction end of the first electrode 10 and a current extraction end of the second electrode 90 are in the same plane. Since the current extraction end of the first electrode 10 and the current extraction end of the second electrode 90 are in the same plane, by connecting the conductive connection member included in one of the two solar cell sheets 100 to the second electrode included in the other of the two solar cells, the series connection of the two solar cells 100 can be achieved. Moreover, since the conductive connection member included in the solar cell sheet 100 does not occupy the plane of the first electrode 10 (i.e., the first transparent conductive layer 20 is far away from the surface of the first doped layer 30), the solar cell sheet 100 provided by some embodiments of the present disclosure reduces a blocking ratio of the conductive connection member 102 (equal to the main gate line in the related art) to the light receiving surface of the solar cell sheet 100, so that the light receiving area of the solar cell sheet 100 is increased. Since the light receiving area of the solar cell sheet 100 is increased, the photoelectric conversion efficiency of the solar cell sheet 100 is improved.

In addition, the solar cell sheet 100 provided by the embodiments of the present disclosure does not need to use a special back plane integrated with positive and negative electrodes. Therefore, the solar cell sheet 100 provided by the embodiments of the present disclosure can realize double-sided solar power generation.

In some embodiments, the conductive connection member 102 described above may be made of metal.

In some embodiments, as shown in Fig. 1 to Fig. 3, the conductive connection member 102 is a connector formed by filling a silver paste. At this time, the connector formed by filling the silver paste is used to make the conductive connection member instead of the pure silver material, which can reduce the manufacturing cost of the solar cell sheet 100 and simplify the manufacturing method of the solar cell sheet 100.

In some embodiments, as shown in Fig. 1 to Fig.3 and Fig. 6, the first electrode 10 includes a plurality of first gate lines b1. The plurality of first gate lines b1 join together, so that an intersection of the plurality of first gate lines b1 forms a first confluence point 11. One end of the conductive connection member 102 is electrically connected to the first confluence point 11. For example, one end of the conductive connection member 102 is electrically connected to the first confluence point 11 by contacting with each other.

A width of each of the plurality of first gate lines b1 is generally set to be from 30µm to 90µm. For example, the width of each of the plurality of first gate lines b1 is 30µm, 90µm, 45µm, or 70µm. A width direction of each of the plurality of first gate lines b1 is perpendicular to a linear direction of a corresponding first gate line of the plurality of first gate lines b1.

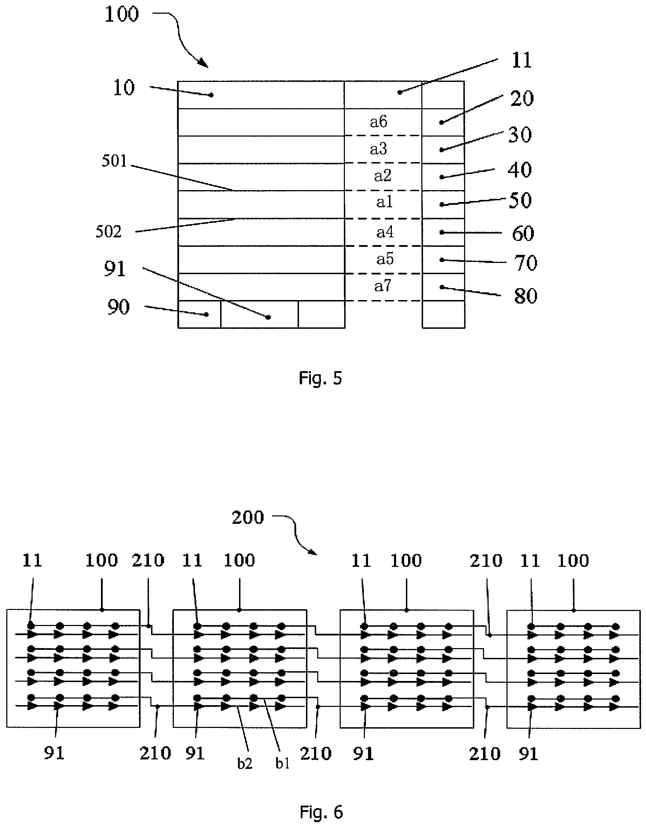

In some embodiments, as shown in Fig. 6, the second electrode 90 includes a plurality of second gate lines b2. The plurality of second gate lines b2 join together, so that an intersection of the plurality of second gate lines b2 forms a second confluence point 91. A width of each of the plurality of first gate lines b2 is generally set to be from 30µm to 90µm. The width of each of the plurality of first gate lines b2 is set to 30µm, 90µm, 45µm or 70µm. A width direction of each of the plurality of second gate lines b2 is perpendicular to a linear direction of a corresponding second gate line of the plurality of second gate lines b2.

In some embodiments, as shown in Fig. 1 to Fig. 4 and Fig. 6, although the other end of the conductive connection member 102 extends to the side of the second transparent conductive layer 80 adjacent to the second electrode 90, because the second electrode 90 includes a plurality of second gate lines b2, the formed second electrode 90 is the second electrode 90 of a grid structure. That is, the second electrode 90 has a hollow portion. Based on this, it is required to ensure that when the other end of the conductive connection member 102 extends to the side of the second transparent conductive layer 80 adjacent to the second electrode 90, the other end of the conductive connection member 102 extends to a side of the second transparent conductive layer 80 adjacent to the hollow portion of the second electrode 90, so that it is possible to prevent the conductive connection member 102 electrically connected to the first confluence point 11 from being electrically connected to the second confluence point 91. Since the conductive connection member 102 electrically connected to the first confluence point 11 is not electrically connected to the second confluence point 91, in the above solar cell sheet 100, the first electrode 10 and the second electrode 90 are not electrically connected, thereby short-circuit will not occur in the solar cell sheet 100.

In some embodiments, as shown in Fig. 6, the first confluence point 11 and the second confluence point 91 are multiple. Accordingly, the number of the above-mentioned conductive connection members 102 is multiple. When the number of the first confluence point 11 and the number of the second confluence point 91 are both multiple, and the number of the conductive connection members 102 is multiple, the number of the conductive connection members 102 is in one-to-one correspondence with the number of the first confluence points 11. In other words, each of the plurality of first junction points 11 corresponds to one conductive connection member 102, so as to guide each of the plurality of first confluence points 11 to the surface of the second electrode 90 adjacent to the second transparent conductive layer 80, so that the current extraction end of the first electrode 10 and the current extraction end of the second electrode 90 are located on the same side of the solar cell sheet 100.

In some embodiments, as shown in Fig. 1 to Fig. 5, the monocrystalline silicon wafer 50 is provided with a first through hole a1. The first passivation layer 40 is provided with a second through hole a2. The first doped layer 30 is provided with a third through hole a3. The second passivation layer 60 is provided with a fourth through hole a4. The second doped layer 70 is provided with a fifth through hole a5. The first transparent conductive layer 20 is provided with a sixth through hole a6, and the second transparent conductive layer 80 is provided with a seventh through hole a7. The first through hole a1, the second through hole a2, the third through hole a3, the fourth through hole a4, the fifth through hole a5, and the sixth through hole a6, the seventh through hole a7 communicate with each other to constitute a through hole 101. That is, the solar cell sheet 100 is provided with the through hole 101, so that the conductive connection member 102 is disposed in the through hole 101.

When the conductive connection member 102 is disposed in the through hole 101, an orthographic projection of the conductive connection member 102 on one surface of the monocrystalline silicon wafer 50 at least overlaps with an orthographic projection of the first confluence point 11 on one surface of the monocrystalline silicon wafer 50. At this time, the first confluence point 11 is located at an end of the sixth through hole a6 of the first transparent conductive layer 20 away from the first doped layer 30. At the same time, an orthographic projection of the conductive connection member 102 on one surface of the monocrystalline silicon wafer 50 and an orthographic projection of the second confluence point 91 on one surface of the monocrystalline silicon wafer 50 are independent from each other to avoid the conductive connection member 102 is electrically connected to the second confluence point 91.

In some embodiments, as shown in Fig. 1 to Fig. 5, when the number of the first confluence point 11 and the second confluence point 91 is multiple, and the number of the conductive connection members 102 is multiple, the number of the through hole 101 is multiple. The plurality of conductive connection members are located in the plurality of the through holes 101 in a one-to-one correspondence.

As shown in Fig. 1 and Fig. 6, the plurality of the through holes 101 are arranged in an nxn array, where n is an integer greater than or equal to 3. For example, when n=3-8, the nxn array is a 3x3 array, a 4x4 array, ..., an 8x8 array, or the like.

In some embodiments, as shown in Fig. 1 to Fig. 3, the first transparent conductive layer 20 and the second transparent conductive layer 80 are both TCO glass conductive layers.

In some embodiments, as shown in Fig. 1 to Fig. 3, the first doped layer 30 and the second doped layer 70 are combined to be a PN junction by the following two implementation manners, so that the solar cell sheet is a solar cell sheet of a PIN structure.

In the first implementation manner, the first doped layer 30 is an N-type amorphous silicon-based doped layer, and the second doped layer 70 is a P-type amorphous silicon-based doped layer.

In the second implementation manner, as shown in Fig. 1 to Fig. 3, the first doped layer 30 is a P-type amorphous silicon-based doped layer, and the second doped layer 70 is an N-type amorphous silicon-based doped layer.

In some embodiments, as shown in Fig. 1 to Fig. 3, the first passivation layer 40 and the second passivation layer 60 are both amorphous silicon basic intrinsic passivation layers.

In some embodiments, when the first transparent conductive layer 20 and the second transparent conductive layer 80 are both conductive layers, and when the first transparent conductive layer 20 is provided with a sixth through hole a6, and the second transparent conductive layer 80 is provided with a seventh through hole a7, a part of the conductive connection member 102 is located in the sixth through hole a6 and the seventh through hole a7. At this time, the conductive connection member 102 may influence the photoelectric conversion efficiency of the solar cell sheet 100. With respect to this problem, an inner wall of the through hole 101 is provided with an insulating film c. The material of the insulating film c is an ethylene-vinyl acetate copolymer (EVA), polyvinyl butyral (PVB) or Dai Nippon Printing(DNP) material.

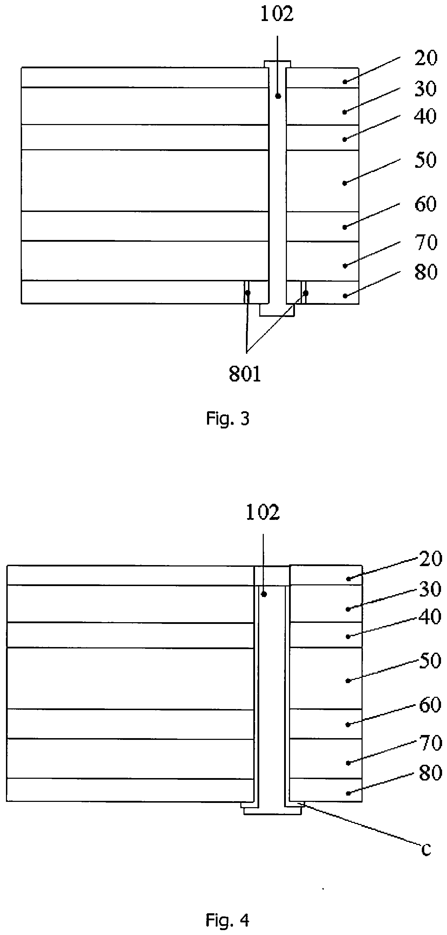

In some embodiments, referring to Fig. 3 and Fig. 4, if the conductive connection member 102 extends out of the second transparent conductive layer 80 along a direction from the second transparent conductive layer 80 to the second electrode 90, and a portion of the conductive connection member 102 extending out of the second transparent conductive layer 80 is in contact with the surface of the second transparent conductive layer 80 adjacent to the second electrode 90, then the first electrode 10 connected to the conductive connection member 102 is electrically connected with the second transparent conductive layer 80. Since the first electrode 10 connected to the conductive connection member 102 is electrically connected to the second transparent conductive layer 80, the first electrode 10 and the second electrode 90 are connected together, and then the solar cell sheet 100 has a short circuit problem. From another perspective, since the first transparent conductive layer 20 and the second transparent conductive layer 80 are both conductive layers having an electrical conductivity, in order to prevent the first transparent conductive layer 20 and the second transparent conductive layer 80 from affecting the current collection of the first electrode 10 and the second electrode 90, it is necessary to perform an insulation treatment at a position where the first transparent conductive layer 20 and the second transparent conductive layer 80 contact the conductive connection member. Since a polarity of the first electrode 10 connected to the first transparent conductive layer 20 is the same as that of the conductive connection member 102, the first transparent conductive layer 20 in contact with the first electrode 10 may not be performed an insulation treatment. The polarity of the second electrode 90 connected to the second transparent conductive layer 80 is opposite to the polarity of the conductive connection member 102. Therefore, the second transparent conductive layer 80 in contact with the second electrode 90 needs an insulation treatment.

In one implementation, as shown in Fig. 4, the insulating film *c* further covers the surface of the second transparent conductive layer 80 contacting the conductive connection member 102, that is, the surface of the second transparent conductive layer 80 contacting the conductive connection member 102 is also provided with an insulating film *c*. The insulating film *c* may insulate the conductive connection member 102 from the second transparent conductive layer 80.

In another implementation manner, as shown in Fig. 3 and Fig. 5, an insulating hole 801 having an annular structure is formed on the second transparent conductive layer 80. The orthographic projection of the insulating hole 801 on the plane of one of the surfaces of the monocrystalline silicon wafer 50 is an annular orthographic projection. The orthographic projection of the through hole 101 on the plane of the one of the surfaces and the orthographic projection of the conductive connection member 102 on the plane of the one of the surfaces are located in a region enclosed by the annular orthographic projection. Since the orthographic projection of the through hole 101 on the plane of the one surface is located in the region surrounded by the annular orthographic projection, the region surrounded by the second transparent conductive layer 80 corresponding to the annular orthographic projection is insulated from the region of the transparent conductive layer 80 corresponding to the outside of the annular orthographic projection. Since the region surrounded by the second transparent conductive layer 80 corresponding to the annular orthographic projection is insulated from the region of the transparent conductive layer 80 corresponding to the outside of the annular orthographic projection, and the orthographic projection of the through hole 101 on the plane of the one of the surfaces and the orthographic projection of the conductive connection member on the plane of the one of the surfaces are located within the region surrounded by the annular orthographic projection, the second transparent conductive layer 80 and the conductive connection member 102 are insulated from each other.

In addition, when a plurality of second gate lines b2 included in the second electrode 90 join together at a second confluence point 91, the second confluence point 91 should be spatially offset from the insulating hole 801 and the through hole 101 to ensure that the conductive connection member 102 disposed in the through hole 101 and the second confluence point 91 are in an insulated state. In other words, the orthographic projection of the second confluence point 91 on the plane of the one of the surfaces is outside the region enclosed by the annular orthographic projection. At this time, although the conductive connection member 102 is inserted in the region surrounded by the transparent conductive layer 80 corresponding to the annular orthographic projection, the conductive connection member 102 will not be electrically connected with the second confluence point 91 formed by joining the plurality of second gate lines b2 included in the second electrode 90. Therefore, although the above-mentioned conductive connection member 102 electrically connected to the first electrode is inserted in the region surrounded by the annular orthographic projection corresponding to the transparent conductive layer 80, the first electrode 10 connected with the conductive connection member 102 will not be electrically connected to the second electrode 90 contacting the second transparent conductive layer 80.

In some embodiments, referring to Fig. 3 to Fig. 5, after the conductive connection member 102 is formed in the through hole 100, if the conductive connection member 102 extends out of the second transparent conductive layer 80 along the direction from the second transparent conductive layer 80 to the second electrode 90, and contacts the surface of the second transparent conductive layer 80 adjacent to the second electrode 90, then a length of a portion of the conductive connection member 102 protruding from the second transparent conductive layer 80 in a radial direction of the through hole 101 is greater than a radial length of the through hole 101. In order to ensure the insulation function of the above-mentioned insulating hole 801, the above-mentioned insulating hole 801 should be far away from the conductive connection member 102. Compared with the insulating manner of forming the insulating film *c* on the inner wall of the through hole 101 and the surface of the second transparent conductive layer 80 contacting the conductive connection member 102, the insulating manner in which an insulating hole 801 is formed in the second transparent conductive layer 80 is simpler and easier to operate.

In addition, as shown in Fig. 3, although the first doped layer 30 and the second doped layer 70 described above are conductive, the conductivity performance thereof almost may be negligible. Therefore, it is only necessary to open the insulating hole 801 on the second transparent conductive layer 80.

As shown in Fig. 1 to Fig. 5, the solar cell sheet 100 provided by some embodiments of the present disclosure guides the electrode (i.e., the first electrode 10) on one side of the solar cell sheet 100 to the other side (i.e., the surface of the second transparent conductive layer 80 adjacent to the second electrode 90) of the solar cell sheet 100 by the conductive connection member 102. When it is necessary to interconnect at least two solar cell sheets 100, the electrodes having different polarities of adjacent two solar cell sheets 100 may be interconnected by the conductive connecting line 210. Since the first electrode 10 and the second electrode 90 are guided to the same surface of the solar cell sheet 100, the conductive connecting line 102 does not affect an area of the light-receiving surface on the surface on which the first electrode 10 of the solar cell sheet 100 is located. Since the conductive connecting line 102 does not affect the area of the light-receiving surface on the other surface of the solar cell, the area of the light-receiving surface of the solar cell sheet 100 is relatively increased, so that the short-circuit current density is increased. Due to the short-circuit current density of the solar cell sheet 100, the photoelectric conversion efficiency of the solar cell sheet 100 is increased.

In some embodiments, as shown in Fig. 2 to Fig. 4, the conductive connection member 102 is a connection member formed by filling silver paste. Compared with the method of directly using the silver paste to form the main gate line, the connection member formed by filling the silver paste can save a large amount of silver paste, therefore, the above-mentioned conductive connection member 102 being the connection member formed by filling the silver paste can greatly reduce the cost of the solar cell sheet 100.

In other embodiments, when preparing the conductive connection member 102, it is not necessary to use silver material, and only a general metal material such as a copper or a tin-plated copper is used, therefore, the manufacturing cost of the above-mentioned conductive connection member 102 is relatively low.

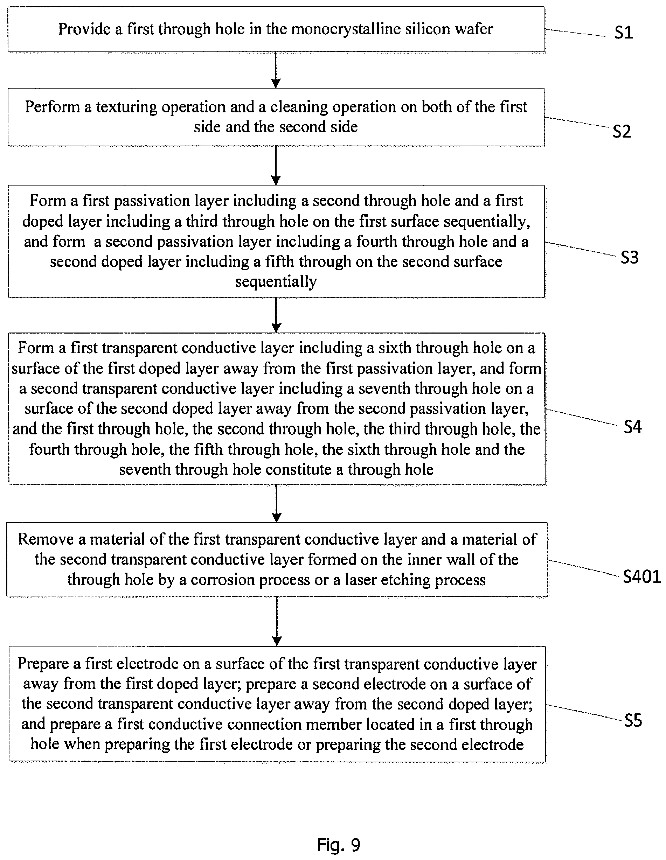

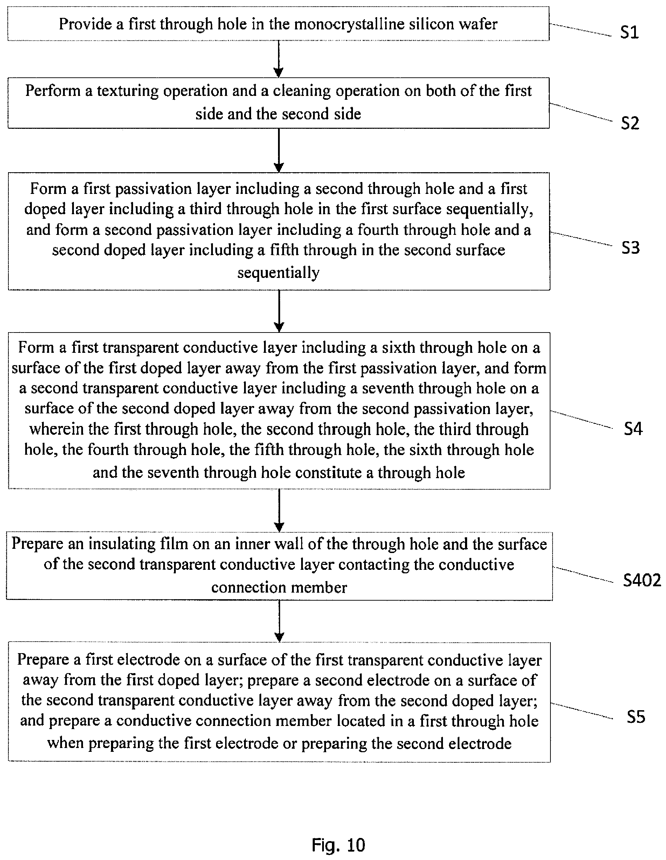

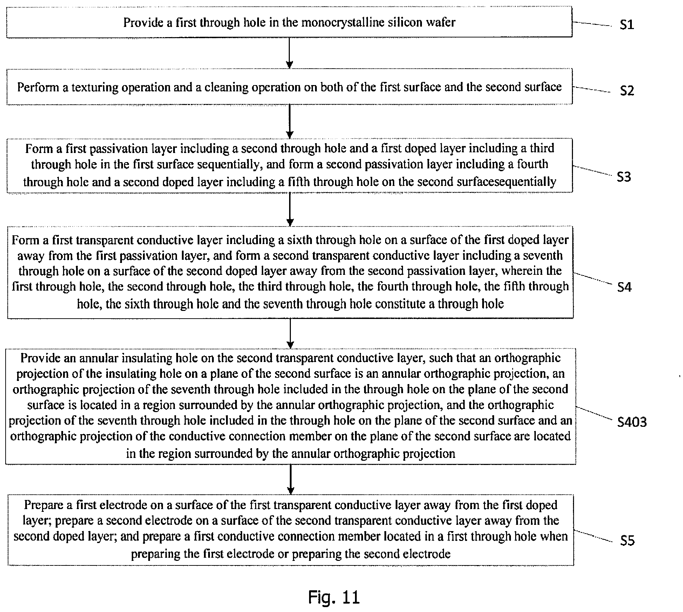

As shown in Fig. 1 to Fig. 5 and Fig. 9 to Fig. 11, some embodiments of the present disclosure further provide a method for preparing a solar cell sheet, and the method for preparing the solar cell sheet 100 includes: step 1 (S1), step 2 (S2), step 3 (S3), step 4 (S4), and step 5 (S5).

In S1, a first through hole a1 is formed in the monocrystalline silicon wafer 50, and the monocrystalline silicon wafer 50 includes a first surface 501 and a second surface 502 which are opposite with each other. There are many ways for forming the first through hole a1 in the monocrystalline silicon wafer 50. For example, the first through hole a1 is formed in the monocrystalline silicon wafer 50 by laser drilling.

In S2, the first surface 501 and the second surface 502 are both subjected to a texturing operation and a cleaning operation. The texturing operation means forming a suede, namely a hairy and rough surface, i.e. not a smooth surface, having a pyramidal pattern on both the first surface 501 and the second surface 502, and a size (a maximum span) of the pyramid is 1µm to 10µm. The texturing operation may reduce the reflectance of the surface of the monocrystalline silicon wafer 50, so as to increase the photoelectric conversion efficiency of the prepared solar cell sheet 100.

In S3, the first passivation layer 40 and the first doped layer 30 are sequentially formed on the first surface 501 described above. A second passivation layer 60 and a second doped layer 70 are sequentially formed on the second surface 502 described above.

In some embodiments, the sequentially forming the first passivation layer 40 and the first doped layer 30 on the first surface 501 includes: sequentially depositing a first passivation layer 40 and a first doping layer 30 on the first surface 501, so that the first passivation layer 40 includes a second through hole a2, and the first doped layer 30 includes a third through hole a3. And the orthographic projections of the first through hole a1, the second through hole a2, and the third through hole a3 on the plane where the first surface 501 is located are overlapped.

The forming sequentially the second passivation layer 60 and the second doped layer 70 on the second surface 502 includes: sequentially depositing a second passivation layer 60 and a second doped layer 70 on the second surface 502, so that the second passivation layer 60 includes a fourth through hole a4, and the second doped layer 70 includes a fifth through hole a5. And the orthographic projections of the first through hole a1, the fourth through hole a4, and the fifth through hole a5 on the plane of the second surface 502 are overlapped.

In some embodiments, the deposition method may be a Plasma Enhanced Chemical Vapor Deposition (PECVD) or a Hot Wire Chemical Vapor Deposition (HWCVD). The two passivation layers of the first passivation layer 40 and the second passivation layer 60, and the two doped layers of the first doped layer 30 and the second doped layer 70 are deposited in the same manner. The first passivation layer 40 and the second passivation layer 60 are deposited in the same step but in different chambers.

Illustratively, the first passivation layer 40 and the second passivation layer 60 are simultaneously formed in the same chamber, and then the first doped layer 30 and the second doped layer 70 are formed in another chamber.

In some embodiments, the first doped layer 30 is an N-type amorphous silicon-based doped layer. The second doped layer 70 is a P-type amorphous silicon-based doped layer.

In some other embodiments, the first doped layer 30 is a P-type amorphous silicon-based doped layer. The second doped layer 70 is an N-type amorphous silicon-based doped layer.

In some embodiments, the first passivation layer 40 and the second passivation layer 60 are both amorphous silicon basic passivation layers.

In S4, a first transparent conductive layer 20 is formed on the surface of the first doped layer 30 away from the first passivation layer 40. A second transparent conductive layer 80 is formed on the surface of the second doped layer 70 away from the second passivation layer 60.

In some embodiments, forming the first transparent conductive layer 20 on the surface of the first doped layer 30 away from the first passivation layer 40 includes: depositing the first transparent conductive layer 20 on the surface of the first doped layer 30 away from the first passivation layer 40, so that the first transparent conductive layer 20 includes a sixth through hole a6. The orthographic projections of the first through hole a1 and the sixth through hole a6 on the plane of the first surface 501 are overlapped.

The forming the second transparent conductive layer 80 on the surface of the second doped layer 70 away from the second passivation layer 60 includes: depositing the second transparent conductive layer 80 on the surface of the second doped layer 70 away from the second passivation layer 60, so that the second transparent conductive layer 80 includes a seventh through hole a7. The orthographic projections of the first through hole a1 and the seventh through hole a7 on the plane of the second surface 502 are overlapped.

The above deposition method may be a Physical Vapor Deposition (PVD), or may be a remote plasma coating method. The remote plasma coating method is also called as Plasma Reactive Deposition (PRD).

The first through hole a1, the second through hole a2, the third through hole a3, the fourth through hole a4, the fifth through hole a5, the sixth through hole a6, and the seventh through hole a7 are communicated to form the through hole 101.

In some embodiments, the first transparent conductive layer 20 and the second transparent conductive layer 80 are both TCO glass conductive layers.

In S5, the first electrode 10 is prepared on the surface of the first transparent conductive layer 20 away from the first doped layer 30. The second electrode 90 is prepared on the surface of the second transparent conductive layer 80 away from the second doped layer 70. Moreover, the conductive connection member 102 located in the first through hole a1 is prepared when preparing the first electrode 10 or preparing the second electrode 90.

In some embodiments, the step of preparing the first electrode 10 on the surface of the first transparent conductive layer 20 away from the first doped layer 30 and the step of preparing the second electrode 90 on the surface of the second transparent conductive layer 80 away from the second doped layer 70 are performed successively.

The preparing the conductive connection member 102 in the first through hole a1 when preparing the first electrode 10 or preparing the second electrode 90 includes:
preparing the conductive connection member 102 located in the through hole 101 when preparing the first electrode 10 or when preparing the second electrode 90.

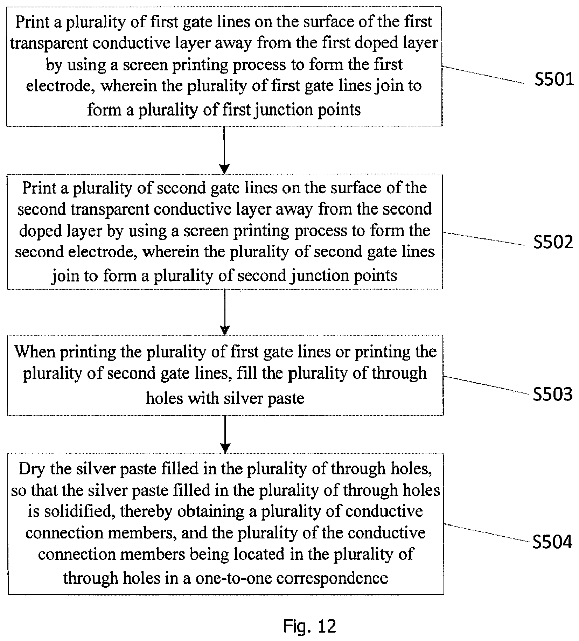

In some embodiments, when the number of the through holes is multiple, the foregoing S1 includes:
forming a plurality of first through holes a1 on the monocrystalline silicon wafer 50 by laser drilling; and/or
as shown in Fig. 1 to Fig. 6 and Fig. 12, the preparing the first electrode 10 on the surface of the first transparent conductive layer 20 away from the first doped layer 30 includes step 501 (S501); and/or
in S501, a plurality of first gate lines b1 are printed on the surface of the first transparent conductive layer 20 away from the first doped layer 30 by a screen printing process to form a first electrode 10 composed of a plurality of first gate lines b1, the plurality of first gate lines b1 join to form a plurality of first confluence points 11, and the orthographic projections of the plurality of first confluence points 11 on the plane of the first surface 501 are located in the orthographic projections of the through holes 101 on the plane of the first surface 501 in a one-to-one correspondence; and/or
as shown in Fig. 1 to Fig. 6 and Fig. 12, the preparing the second electrode 90 on the surface of the second transparent conductive layer 80 away from the second doped layer 70 includes step 502 (S502),
in S502, a plurality of second gate lines b2 are printed on the second transparent conductive layer 80 by a screen printing process to form a second electrode 90 composed of a plurality of second gate lines b2, the plurality of second gate lines b2 join to form a plurality of second confluence points 91, and the orthographic projections of the plurality of second confluence points 91 on the plane of the second surface 502 are outside the annular orthographic projection of the insulating hole 801 on the plane of the second surface 502 in a one-to-one correspondence; and/or
the preparing the conductive connection member in the first through hole a1 when preparing the first electrode 10 or when preparing the second electrode 90 includes: step 503 (S503) and step 504 (S504).

In S503, when printing the plurality of first gate lines b1 or printing the plurality of second gate lines b2, filling the plurality of through holes a5 with silver paste.

In S504, drying the silver paste filled in the plurality of through holes 101, so that the silver paste filled in the plurality of the through holes 101 is solidified, thereby a plurality of conductive connection members 102 are obtained, and the plurality of conductive connection members 102 are located in the plurality of the through holes 101 in a one-to-one correspondence.

Since the orthographic projections of the plurality of first confluence points 11 on the plane of the first surface 501 are located within the orthographic projection of the first through hole a1 on the plane of the first surface 501, and the orthographic projections of the plurality of second confluence points 91 on the plane of the second surface 502 and the orthographic projection of the first through hole a1 on the plane of the second surface 502 are independent from each other, when the plurality of conductive connection members 102 are located in the plurality of the through holes 101 in a one-to-one correspondence, one ends of the plurality of conductive connection members 102 may be electrically connected to the first confluence point 11 in a one-to-one correspondence, the other ends of the plurality of conductive connection members 102 are not electrically connected to the plurality of second confluence points 91.

It may be seen that: after the plurality of conductive connection members 102 are formed in the plurality of through holes 100 in a one-to-one correspondence, the current extraction end of the first electrode 10 is led out through the plurality of conductive connection members 102 to the surface of the second transparent conductive layer 80 adjacent to the second electrode 90, so that the current extraction end of the first electrode 10 is located on the same side as the second electrode 90.

In some embodiments, the first electrode 10 and the second electrode 90 are made of the silver paste and a resin material.

Illustratively, the silver paste and the resin material are mixed to form a premix with a mass percent greater than 90%. The premix is printed on the surface of the second transparent conductive layer 80 away from the second doped layer 70 by the screen printing process, so that a plurality of second gate lines b2 are formed on the surface of the second transparent conductive layer 80 away from the second doped layer 70. Similarly, a premix is printed on the surface of the first transparent conductive layer 20 away from the first doped layer 30 by the screen printing process, so that a plurality of second gate lines b2 are formed on the surface of the first transparent conductive layer 20 away from the first doped layer 30.

In some embodiments, as shown in Fig. 1 to Fig. 5, the first passivation layer 40, the first doped layer 30, the first transparent conductive layer 20, the second passivation layer 60, the second doped layer 70 and the second transparent conductive layer 80 have a thickness of nanometer, and the through hole 101 has a diameter of millimeter. Therefore, when depositing the first passivation layer 40, the first doped layer 30, the first transparent conductive layer 20, the second passivation layer 60, the second doped layer 70, and the second transparent conductive layer 80, an upper end of the inner wall of the first through hole a1 (the first through hole a1 is located at the end of the direction of the first surface 501) is likely to be adhered with a first deposition layer formed of the material of the first passivation layer 40, the material of the first doped layer 30, and the material of the first transparent conductive layer 20. The first deposition layer is a three-layer structure formed by the material of the first passivation layer 40, the material of the first doped layer 30, and the material of the first transparent conductive layer 20. The lower end of the inner wall of the first through hole a1 (the first through hole a1 is located at the end of the direction of the second surface) may be adhered with the second deposited layer formed of the material of the second passivation layer 60, the material of the second doped layer 70, and the material of the second transparent conductive layer 80. The second deposition layer is a three-layer structure formed by the material of the second passivation layer 60, the material of the second doped layer 70, and the material of the second transparent conductive layer 80. Since the material of the first transparent conductive layer 20 and the material of the second transparent conductive layer 80 are conductive, if the material of the first transparent conductive layer 20 and the material of the second transparent conductive layer 80 adhered to the inner wall of the first through hole a1 are not removed, the conductive connection member 102 connected to the first electrode 10 may contact the second transparent conductive layer 80 connected to the second electrode 90, thereby affecting the polarity of the conductive connection member 102. Since the conductive connection member 102 connected to the first electrode 10 contacts the second transparent conductive layer 80 connected to the second electrode 90, the first electrode 10 and the second electrode 90 of the solar cell sheet 100 are connected together, so that the above solar cell sheet 100 is short-circuited. Therefore, it is necessary to perform an insulation process on the inner wall of the through hole 101. In addition, although the first doped layer 30 and the second doped layer 70 may also conduct electricity, their electrical conductivity may be almost negligible. Therefore, only the material of the first transparent conductive layer 20 and the material of the second transparent conductive layer 70 in the through hole 101 need to be processed.

In one embodiment, as shown in Fig. 1 to Fig. 4 and Fig. 9, after step S4, and before step S5, the method for preparing the above solar cell sheet 100 further includes step 401 (S401).

In S401, the material of the first transparent conductive layer 20 and the material of the second transparent conductive layer 80 formed in the inner wall of the through hole 101 (for example, the forming manner is deposition manner) are removed by a corrosion process or a laser etching process. When the material of the first transparent conductive layer 20 and the material of the second transparent conductive layer 80 formed in the inner wall of the through hole 101 are removed by the corrosion process, it is possible to use a strong alkali to corrode the material of the first transparent conductive layer 20 and the material of the second transparent conductive layer 80 formed in the inner wall of the through hole 101. The strong alkali includes an inorganic alkali such as sodium hydroxide or potassium hydroxide.

Since a total thickness of the first passivation layer 40, the first doped layer 30, the first transparent conductive layer 20, the second passivation layer 60, the second doped layer 70, and the second transparent conductive layer 80 is nanometer scale, for convenience of operation, the material of the first transparent conductive layer 20 and the material of the second transparent conductive layer 80 formed on the inner wall of the through hole 101 consisting of the first through hole a1, the second through hole a2, the third through hole a3, the fourth through hole a4, the fifth through hole a5, the sixth through hole a6, and the seventh through hole a7 may be corroded for one time, in this way, the method of removing the material of the first transparent conductive layer 20 and the material of the second transparent conductive layer 80 is simple and convenient to operate, and has a high reliability.

Illustratively, the first doped layer has a thickness of 6 nm, the second doped layer has a thickness of 8 nm, and the first transparent conductive layer 20 and the second transparent conductive layer 80 both have a thickness of 80 nm.

In some embodiments, as shown in Fig. 2, Fig. 4, Fig. 5 and Fig. 9, after step S4, and before step S5, the method for preparing the solar cell sheet 100 further includes step 402 (S402).

In S402, an insulating film c is prepared on the inner wall of the through hole 101 and the surface of the second transparent conductive layer 80 for contacting the conductive connection member 102. The insulating film c is an ethylene-vinyl acetate copolymer (EVA) material layer, a polyvinyl butyral material layer or a Dai Nippon Printing (DNP) plastic layer. Since the material of the first transparent conductive layer 20 and the material of the second transparent conductive layer 80 are conductive materials, in order to prevent the material of the first transparent conductive layer 20 and the material of the second transparent conductive layer 80 on the inner wall of the through hole 101 from affecting the current collection by the electrode, in particular, it is necessary to provide an insulating film on the inner wall of the sixth through hole a6 included in the through hole 101 and the inner wall of the seventh through hole a7 included in the through hole 101. Since the first passivation layer 40, the first doped layer 30, the first transparent conductive layer 20, the second passivation layer 60, the second doped layer 70, and the second transparent conductive layer 80 have a total thickness of nanometer scale, the insulating film *c* is entirely provided on the inner wall of the through hole 101, and it is not necessary to define the position where the insulating film c is formed, so that it is convenient to form the insulating film con the inner wall of the through hole 101. Further, providing the insulating film *c* entirely on the inner wall of the through hole 101 can also ensure a good insulation between the conductive connection member 102 and the first transparent conductive layer 20, the second transparent conductive layer 80.

Referring to Fig. 3, if the conductive connection member 102 extends out of the second transparent conductive layer 80 along the direction from the second transparent conductive layer 80 to the second electrode 90, and a portion of the conductive connection member 102 extending out of the second transparent conductive layer 80 is in contact with the lower surface of the second transparent conductive layer 80 (the surface adjacent to the second electrode 90), then the first electrode 10 connected to the conductive connection member 102 is electrically connected with the second transparent conductive layer 80. In order to prevent the first electrode 10 connected to the conductive connection member 102 from being electrically connected to the second transparent conductive layer 80, the above insulating film *c* is also formed on the surface of the second transparent conductive layer for contacting the conductive connection member, so that the conductive connection member 102 is insulated from the second transparent conductive layer 80 by the insulating film c, thereby preventing the first electrode 10 connected to the conductive connection member 102 from electrically connecting to the second electrode 90 in contact with the second transparent conductive member 80.

In some other embodiments, as shown in Fig. 3, Fig. 5, and Fig. 10, the insulation process may be performed after S4, and prior to S5. At this time, after S4, and before the step S5, the method for preparing the solar cell sheet 100 further includes: step 403 (S403).

In S403, an annular insulating hole 801 is formed in the second transparent conductive layer 80, so that the orthographic projection of the insulating hole 801 on the plane of the second surface 502 is an annular orthographic projection. The orthographic projection of the seventh through hole a7 included in the through hole 101 on the plane of the second surface 502 is located in the region surrounded by the annular orthographic projection. The orthographic projection of the seventh through hole a7 included in the through hole 101 on the plane of the second surface 502 and the orthographic projection of the conductive connection member 102 on the plane of the second surface 502 are both located in the region enclosed by the annular orthographic projection, and the orthographic projection of the second confluence point 91 on the plane of the second surface 502 is outside the region enclosed by the annular orthographic projection. At this time, the region surrounded by the second transparent conductive layer 80 corresponding to the annular orthographic projection is not only insulated from the outer region of the second transparent conductive layer 80 corresponding to the annular orthographic projection, but also insulated from the second electrode 81. Since the region surrounded by the second transparent conductive layer 80 corresponding to the annular orthographic projection is electrically connected to the conductive connection member 102, by providing the insulating hole 801 on the second transparent conductive layer 102, the insulating holes 801 may insulate the conductive connection members 102 from the second transparent conductive layer 80 and the second electrode 90.

The manner in which the second transparent conductive layer 80 and the conductive connection member 102 are insulated by the insulating holes 801 is simpler and easier to operate. The first transparent conductive layer 20 is in contact with the first electrode 10, and the conductive connection member 102 is electrically connected to the first electrode, therefore the polarity of the first transparent conductive layer 20 is the same as that of the conductive connection member 102, and the conductive connection members 102 can be insulated from the second transparent conductive layer 80 and the second electrodes by only providing the insulating holes 801 in the second transparent conductive layer 80.

Fig. 6 shows a first cell string, wherein the portion for connecting in parallel the first cell string by an interconnecting strip is omitted, and those skilled in the art may understand in accordance with conventional technical means.

As shown in Fig. 6, an embodiment of the present disclosure further provides a solar cell string 200. The solar cell string 200 includes a plurality of solar cell sheets 100 that are electrically connected together.

Compared with the related art, the beneficial effects of the solar cell string 200 provided by the embodiments of the present disclosure are the same as those of the solar cell sheet 100 provided by the above embodiments, which are not described herein.

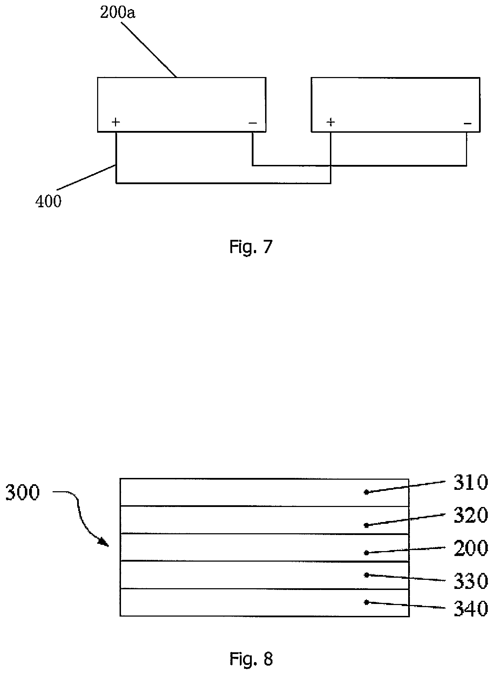

It should be understood by those skilled in the art that, as shown in Fig. 6 and Fig. 7, when the plurality of solar cell sheets 100 are electrically connected together, the electrical connection manner may be a series connection or a parallel connection. When the electrical connection manner is the series connection, the first electrode 10 of one of the adjacent two solar cell sheets 100 and the second electrode 90 of the other solar cell sheet 100 are connected by a conductive connecting line 210. When the electrical connection mode is the parallel connection, the first electrode 10 of one of the adjacent two solar cell sheets 100 and the first electrode 10 of the other solar cell sheet 100 are connected by the conductive connecting line 210.

In some embodiments, as shown in Fig. 7, a plurality of the solar cell sheets 100 connected together constitute at least two cell substrings 200a connected in parallel. The plurality of cell substrings 200a are connected in parallel by an interconnecting strips 400 to form the solar cell string 200.

As shown in Fig. 6, in each of the plurality of cell substrings 200a, the conductive connection member 102 included in one of the adjacent two solar cell sheets 100 and the second electrode 90 included in the other solar cell sheet are electrically connected through the conductive connecting line 210, so that the adjacent two solar cell sheets 100 are connected in series.

As shown in Fig. 7, when the solar cell string 200 is formed in parallel, one of the interconnecting strips 400 connects the conductive connection members 102 included in the bottommost solar cell sheets included in the adjacent two cell substrings 200a, thus the first electrodes 10 of the plurality of cell substrings are electrically connected together; and the other interconnecting strip 400 electrically connects the second electrodes 90 included in the bottommost solar cell sheets included in the adjacent two cell sub-strings 200a, thus the second electrodes 90 of the plurality of cell substrings are electrically connected, in this way, a solar cell string 200 is obtained.

In some embodiments, as shown in Fig. 1 to Fig. 6, when the two adjacent two solar cell sheets 100 are connected in series, the first electrode 10 included in one of the adjacent two solar cell sheets 100 is electrically connected to the second electrode 90 included in the other solar cell sheet.

Illustratively, as shown in Fig. 1 to Fig. 6, the first electrode 10 included in one of the adjacent two solar cell sheets 100 and the second electrode 90 included in the other solar cell sheet are connected by a conductive connecting line 210. At this time, it is necessary to connect the first confluence point 11 included in one of the adjacent two solar cell sheets 100 and the second confluence point 91 included in the other solar cell sheet by the conductive connecting line 210. Since the first confluence point 11 in each solar cell sheet 100 is electrically connected to the conductive connection member 102, and the other end of the conductive connection member 102 extends to the surface of the second transparent conductive layer 80 away from the second doped layer 70, when the first confluence point 11 included in one of the adjacent two solar cell sheets 100 and the second confluence point 91 included in the other solar cell sheet are connected by the conductive connecting line 210, the conductive connection member 102 included in one of the adjacent two solar cell sheets 100 and the second confluence point 91 included in the other solar cell sheet are connected by the conductive connecting line 210.

Illustratively, the conductive connection member 102 has a thickness of 0.01 mm to 0.2 mm and a width of 0.6 mm to 12 mm. Compared with the conventional silver main gate line, the above-mentioned conductive connecting line 102 is also smaller in size, which reduces the shielding of the light receiving surface of the solar cell sheet 100, thereby improving the conversion efficiency of the solar cell sheet 100.

It may be understood that, as shown in Fig. 1 to Fig. 4, the first confluence point 11 in the solar cell sheet 100 is guided by the conductive connection member 100 to the surface of second transparent conductive layer 80 which is coplanar with the second confluence point 91 and is away from the second doped layer 70. In other words, the first confluence point 11 and the second confluence point 91 are already located on the same surface of the solar cell sheet 100, therefore, one surface of the solar cell sheet 100 realizes the series connection of two adjacent solar cell sheets 100 by the conductive connecting line 210, and the influence of the conductive connecting line 210 on the light receiving surface of the solar cell sheet 100 can be reduced, thereby improving the photoelectric conversion efficiency of the solar cell sheet 100.

The shapes of the first confluence point 11 and the second confluence point 91 in Fig. 6 are different, which is only for distinguishing the first confluence point 11 and the second confluence point 91, and is not intended to limit the shapes of the first confluence point 11 and the second confluence point 91.

In some embodiments, the above conductive connecting line 210 is made of a copper strip. The copper strip may be a pure copper strip or a tinned copper strip, but the present disclosure is not limited thereto.

Illustratively, the outer surface of the above conductive connecting line 210 is coated with a layer of insulating material. For example, the insulating material is preferably a rubber or plastic.

When the conductive connection member 200 included in one of the adjacent two solar cell sheets 100 of the plurality of cell sub-strings is electrically connected to the second electrode 90 included in the other solar cell sheet, it is only necessary to expose the inner tinned copper strip by spot welding or gluing the insulating material at the end of the conductive connecting line 210 to ensure the electrical conductivity.

In some embodiments, the temperature of the spot welding described above does not exceed 200 degrees. The temperature of the above low temperature curing does not exceed 220 degrees.

In addition, as shown in Fig. 7, when the conductive connecting line 210 is electrically connected to the adjacent two cell sub-strings 200a, insulation is realized by providing an insulating film on the outside of the conductive connecting line 210, and the insulating film is the ethylene-vinyl acetate copolymer (EVA) material layer, the polyvinyl butyral (PVB) material layer or the Dai Nippon Printing (DNP) material layer.

As shown in Fig. 8, some embodiments of the present disclosure also provide a photovoltaic module 300. The photovoltaic module 300 includes a front plate 310, a first bonding layer 320, a solar cell string 200, a second bonding layer 330, and a backing plate 340 in an order from top to bottom. The solar cell string 200 is the solar cell string 200 provided in any of the above embodiments.

Compared with the related art, the beneficial effects of the photovoltaic module 300 provided by some embodiments of the present disclosure are the same as those of the solar cell sheet 100 described above, and are not elaborated herein.

In some embodiments, the first bonding layer 320 and the second bonding layer 330 are both ethylene-vinyl acetate copolymer (EVA) material layer and polyvinyl butyral (PVB) material layer, a polyolefin elastomer (POE) material layer or a thermoplastic silicone layer.

## Claims

1. A solar cell sheet (100), comprising: a conductive connection member (102); and a first electrode (10), a first transparent conductive layer (20), a first doped layer (30) of a first conductivity type, a first passivation layer (40), a monocrystalline silicon wafer (50), a second passivation layer (60), a second doped layer (70) of a second conductivity type, a second transparent conductive layer (80), and a second electrode (90) which are arranged in an order from top to bottom, wherein,
one end of the conductive connection member (102) is electrically connected to the first electrode (10), the other end of the conductive connection member (102) extends to a side of the second transparent conductive layer (80) adjacent to the second electrode (90), and the conductive connection member (102) is insulated from the second transparent conductive layer (80) and the second electrode (90).

2. The solar cell sheet (100) according to claim 1, wherein, the first electrode (10) comprises a plurality of first gate lines (b1), the plurality of first gate lines (b1) join together at a first confluence point (11), and the conductive connection member (102) is electrically connected to the first confluence point (11).

3. The solar cell sheet (100) according to claim 1 or claim 2, wherein, the second electrode (90) comprises a plurality of second gate lines (b2), and the plurality of second gate lines (b2) join together at a second confluence point (91).

4. The solar cell sheet (100) according to any one of claims 1 to 3, wherein, the monocrystalline silicon wafer (50) is provided with a first through hole (a1), the first passivation layer (40) is provided with a second through hole (a2), the first doped layer (30) is provided with a third through hole (a3), the second passivation layer (60) is provided with a fourth through hole (a4), the second doped layer (70) is provided with a fifth through hole (a5), the first transparent conductive layer (20) is provided with a sixth through hole (a6), the second transparent conductive layer (80) is provided with a seventh through hole (a7), the first through hole (a1), the second through hole (a2), the third through hole (a3), the fourth through hole (a4), the fifth through hole (a5), the sixth through hole (a6) and the seventh through hole (a7) constitute a through hole (101), and the conductive connection member (102) is disposed in the through hole (101).

5. The solar cell sheet (100) according to claim 4, wherein, a surface of the second transparent conductive layer (80) configured to contacting the conductive connection member (102) and an inner wall of the through hole (101) are provided with an insulating film (c), or
the second transparent conductive layer (80) is provided with an insulating hole (801) having an annular structure; an orthographic projection of the insulating hole (801) on a plane of one of surfaces of the monocrystalline silicon wafer (50) is an annular orthographic projection, and both an orthographic projection of the through hole (101) on the plane of one of the surfaces and an orthographic projection of the conductive connection member (102) on the plane of one of the surfaces are located in the annular orthographic projection; and an orthographic projection of the second confluence point (91) on the plane of one of the surfaces is located outside the annular orthographic projection.

6. A method for preparing a solar cell sheet (100), comprising:
providing (S1) a first through hole (a1) in a monocrystalline silicon wafer (50), the monocrystalline silicon wafer (50) comprising first and second surfaces which are opposite;
performing (S2) a texturing operation and a cleaning operation on both of the first and second surfaces;
forming a first passivation layer (40) and a first doped layer (30) on the first surface sequentially, and forming a second passivation layer (60) and a second doped layer (70) on the second surface sequentially (S3);
forming a first transparent conductive layer (20) on a surface of the first doped layer (30) away from the first passivation layer (40), and forming a second transparent conductive layer (80) on a surface of the second doped layer (70) away from the second passivation layer (60) (S4); and
preparing a first electrode (10) on a surface of the first transparent conductive layer (20) away from the first doped layer (30), preparing a second electrode (90) on a surface of the second transparent conductive layer (80) away from the second doped layer (70), and preparing a conductive connection member (102) located in the first through hole (a1) when preparing the first electrode (10) or preparing the second electrode (90), such that one end of the conductive connection member (102) is connected to the first electrode (10), and the other end of the conductive connection member (102) extends to a side of the second transparent conductive layer (80) adjacent to the second electrode (90) (S5).

7. The method for preparing a solar cell sheet (100) according to claim 6, wherein,
the forming (S3) the first passivation layer (40) and the first doped layer (30) on the first surface sequentially comprises: depositing sequentially the first passivation layer (40) and the first doped layer (30) on the first surface, so that the first passivation layer (40) comprises a second through hole (a2), the first doped layer (30) comprises a third through hole (a3), and orthographic projections of the first through hole (a1), the second through hole (a2), and the third through hole (a3) on a plane of the first surface are overlapped;
the forming (S3) the second passivation layer (60) and the second doped layer (70) on the second surface sequentially comprises: depositing sequentially the second passivation layer (60) and the second doped layer (70) on the second surface, so that the second passivation layer (60) comprises a fourth through hole (a4), the second doped layer (70) comprises a fifth through hole (a5), and orthographic projections of the first through hole (a1), the fourth through hole (a4), and the fifth through hole (a5) on a plane of the second surface are overlapped;
the forming (S4) the first transparent conductive layer (20) on the surface of the first doped layer (30) away from the first passivation layer (40) comprises: depositing the first transparent conductive layer (20) on the surface of the first doped layer (30) away from the first passivation layer (40), so that the first transparent conductive layer (20) comprises a sixth through hole (a6), and orthographic projections of the first through hole (a1) and the sixth through hole (a6) on the plane of the first surface are overlapped;
the forming (S4) the second transparent conductive layer (80) on the surface of the second doped layer (70) away from the second passivation layer (60) comprises: depositing the second transparent conductive layer (80) on the surface of the second doped layer (70) away from the second passivation layer (60), so that the second transparent conductive layer (80) comprises a seventh through hole (a7), and orthographic projections of the first through hole (a1) and the seventh through hole (a7) on the plane of the second surface are overlapped;
the first through hole (a1), the second through hole (a2), the third through hole (a3), the fourth through hole (a4), the fifth through hole (a5), the sixth through hole (a6), and the seventh through hole (a7) form a through hole (101);
the preparing (S5) the first electrode (10) on the surface of the first transparent conductive layer (20) away from the first doped layer (30) and the preparing the second electrode (90) on the surface of the second transparent conductive layer (80) away from the second doped layer (70) are performed sequentially; and
the preparing (S5) the conductive connection member (102) located in the first through hole (a1) when preparing the first electrode (10) or preparing the second electrode (90) comprises:
preparing the conductive connection member (102) located in the through hole (101) when preparing the first electrode (10) or preparing the second electrode (90).

8. The method for preparing a solar cell sheet (100) according to claim 7, wherein, after forming (S4) the second transparent conductive layer, and before preparing (S5) the first electrode (10) and the second electrode (90), the method for preparing the solar cell sheet (100) further comprises:
removing (S401) a material of the first transparent conductive layer (20) and a material of the second transparent conductive layer (80) formed on an inner wall of the through hole (101) by a corrosion process or a laser etching process; or
preparing (S402) an insulating film (c) on the inner wall of the through hole (101) and a surface of the second transparent conductive layer (80) contacting a surface of the conductive connection member (102).

9. The method for preparing a solar cell sheet (100) according to claim 7, wherein, after forming (S4) the second transparent conductive layer, and before preparing (S5) the first electrode (10) and the second electrode (90), the method for preparing the solar cell sheet (100) further comprises:
providing (S403) an insulating hole (801) having an annular structure on the second transparent conductive layer, such that an orthographic projection of the insulating hole (801) formed on the plane of the second surface is an annular orthographic projection, an orthographic projection of the seventh through hole (a7) formed on the plane of the second surface is located within the annular orthographic projection, and the orthographic projection of the seventh through hole (a7) on the plane of the second surface and an orthographic projection of the conductive connection member (102) on the plane of the second surface are located within the annular orthographic projection.

10. The method for preparing a solar cell sheet (100) according to claim 9, wherein, there are a plurality of the through holes (101) and a plurality of the insulating holes (801); orthographic projections of the plurality of the through holes (101) formed on the plane of the second surface are located within annular orthographic projections of the plurality of insulating holes (801) on the plane of the second surface in a one-to-one correspondence.

11. The method for preparing a solar cell sheet (100) according to claim 10, wherein, the providing (S1) the first through hole (a1) on the monocrystalline silicon wafer (50) comprises: forming a plurality of first through holes (a1) on the monocrystalline silicon wafer (50) by laser drilling;
the preparing (S5) the first electrode (10) on the surface of the first transparent conductive layer (20) away from the first doped layer (30) comprises:
printing (S501) a plurality of first gate lines (b1) on the surface of the first transparent conductive layer (20) away from the first doped layer (30) by using a screen printing process, so as to form the first electrode (10); wherein the plurality of first gate lines (b1) join to form a plurality of first confluence points (11), and orthographic projections of the plurality of first confluence points (11) on the plane of the first surface are located within the orthographic projections of the through holes (101) on the plane of the first surface in a one-to-one correspondence;
the preparing (S5) the second electrode (90) on the surface of the second transparent conductive layer (80) away from the second doped layer (70) comprises:
printing (S502) a plurality of second gate lines (b2) on the surface of the second transparent conductive layer (80) away from the second doped layer (70) by using a screen printing process, so as to form the second electrode (90); wherein the plurality of second gate lines (b2) join to form a plurality of second confluence points (91), and orthographic projections of the plurality of second confluence points (91) on the plane of the second surface are located outside the region surrounded by the annular orthographic projections of the plurality of insulating holes (801) formed on the plane of the second surface in a one-to-one correspondence;
the preparing (S5) the conductive connection member (102) located in the first through hole (a1) when preparing the first electrode (10) or preparing the second electrode (90) comprises:
when printing the plurality of first gate lines (b1) or printing the plurality of second gate lines (b2), filling (S503) the plurality of through holes (101) with a silver paste; and
drying (S504) the silver paste filled in the plurality of through holes (101), so that the silver paste filled in the plurality of through holes (101) is solidified, thereby obtaining a plurality of conductive connection members (102), and the plurality of the conductive connection members (102) are located in the plurality of through holes (101) in a one-to-one correspondence.

12. A solar cell string (200), comprising: a plurality of solar cell sheets (100) according to any one of claims 1-5, wherein, the plurality of solar cell sheets (100) are electrically connected together.

13. The solar cell string (200) according to claim 12, wherein,
the plurality of solar cell sheets (100) connected together constitute at least two cell substrings (200a) connected in parallel, each cell substring (200a) comprising a plurality of solar cell sheets (100) connected in series.

14. The solar cell string (200) according to claim 13, wherein, the solar cell string (200) further comprises an interconnecting strip (400) for connecting a plurality of cell substrings (200a) in parallel; and the conductive connection member (102) of one of adjacent two solar cell sheets (100) in each of the plurality of cell substrings (200a) is electrically connected by a conductive connecting line (210) with the second electrode (90) of the other solar cell sheet (100).

15. A photovoltaic module (300), comprising: a front plate (310), a first bonding layer (320), a solar cell string (200), a second bonding layer (330), and a backing plate (340) in an order from top to bottom; wherein the solar cell string (200) is the solar cell string (200) according to any one of claims 12-14.
